# EUROPEAN PATENT SPECIFICATION

(11) **EP 4 392 648 B1**
(45) Date of publication and mention of the grant of the patent: **11.06.2025**
(21) Application number: 22761558.0
(22) Date of filing: 10.08.2022
(51) Int. Cl.: F01K 17/04, B01D 1/28

(54) **AN ENERGY SYSTEM COMPRISING A MECHANICAL VAPOR COMPRESSION (MVC/MVR) SUBSYSTEM AND A METHOD FOR CONVERTING OF ENERGY**
ENERGIESYSTEM MIT EINEM UNTERSYSTEM ZUR MECHANISCHEN DAMPFKOMPRESSION (MVC/MVR) UND VERFAHREN ZUR UMWANDLUNG VON ENERGIE
SYSTÈME D'ÉNERGIE COMPRENANT UN SOUS-SYSTÈME DE COMPRESSION MÉCANIQUE DE LA VAPEUR (CMV/RMV) ET PROCÉDÉ DE CONVERSION D'ÉNERGIE

(30) Priority: 25.08.2021 EP 21193087
(43) Date of publication of application: 03.07.2024
(73) Proprietor: Aquafair AB, 702 18 Örebro (SE)
(72) Inventor: ÅHRSTRÖM, Bert-Olof, 891 43 Örnsköldsvik (SE); CARLMAN, Fredrik, 702 86 Örebro (SE)
(74) Representative: Bjerkén Hynell KB
(86) International application number: PCT/EP2022/072393
(87) International publication number: WO 2023/025589

(56) References cited:
- EP-A1- 3 689 449
- GB-A- 1 233 005
- US-A1- 2002 178 723

## Description

### Technical field

The present invention relates to an energy system comprising a mechanical vapor compression (MVC/MVR) subsystem, in particular it relates to an energy system comprising MVC/MVR liquid purification subsystem. Further, the present invention relates to a method for converting of energy using a MVC/MVR-subsystem.

### Background

Mechanical Vapor Compression (MVC) or also called Mechanical Vapor Recompression (MVR) is an evaporation method by which a blower, compressor or jet ejector is used to compress, and as a result of the compression, increase the pressure, density and temperature of the vapor produced.

As a result, the vapor can serve as the heating medium for its "mother" liquid or solution being concentrated. Without the compression, the vapor would be at the same temperature as its "mother" liquid/solution, and no heat transfer could take place.

Below some patent documents within the technical field will be briefly discussed.

In the US10793483 a system is described using a mechanical vapor recompression evaporator (MVR) to receive a liquid fraction from a centrifuge and evaporating the liquid fraction by mechanical vapor recompression to produce ammonia-laden water vapor and a concentrated nutrient slurry. The system comprises a dryer for drying the nutrient slurry to a selected moisture content to be available as an ingredient in compounded fertilizer; and
an ammonia stripping tower assembly to receive ammonia-laden water vapor from the MVR and from it to precipitate ammonium sulphate salt and condense water as separate products.

In the EP2716341 a system and a method is described for liquid treatment by mechanical vapor recompression comprising a fixed fluid-tight evaporator housing. The housing comprises an inlet for feeding liquid to be evaporated into the housing and an outlet from the housing for liquid concentrated by evaporation and an outlet from the housing for discharging vapor boiled off from the liquid by evaporation. The housing comprises a plurality of heating elements within the housing mounted on a common horizontal axis, each of said heating elements having an outer surface for contact with said liquid to be evaporated within the housing and having an internal passage for heating medium and an element inlet and an element outlet for the heating medium.

In the EP3689449 a system for energy recycling using mechanical vapor recompression in combined chemical process is described. GB1233005A and US20020178723 A1 also disclose MVC/MVR systems.

Although the known systems work well, there is a need of improvements regarding utilization of energy from a MVC/MVR in an efficient manner.

Thus, the general object of the present disclosure is to achieve an energy system comprising a mechanical vapor recompression (MVC/MVR) subsystem, which energy system has conditions for an improved utilization of energy from the MVC/MVR-subsystem. Further, an object of the present disclosure is to achieve an improved method for converting of energy using a MVC/MVR-subsystem in an efficient manner.

### Summary

The above-mentioned objects are achieved by the present invention according to the independent claims.

Preferred embodiments are set forth in the dependent claims.

According to one aspect of the invention an energy system is described in claim 1.

The MVC/MVR-subsystem is a subsystem arranged to operate according to MVR-principle where compressed vapor is reused. The MVR-subsystem is arranged in a specific way characteristic for MVR technology.

The MVR-subsystem is arranged as a closed loop vapor MVR-subsystem arranged to reuse the produced vapor. Thus, vapor can be used in an efficient manner by being reused in the MVR-subsystem.

The energy system comprises an energy subsystem connected to the MVC/MVR-subsystem and arranged to convert energy in a branched portion of the compressed vapor and/or in at least a portion of the liquid being heated into cooling by a cooling apparatus comprised by the energy subsystem and/or to generate electricity by an electric apparatus comprised by the energy subsystem.

At least a portion of the liquid being heated means that the entire volume of the heated liquid can be used in the energy subsystem or a portion of the heated liquid can be used in the energy subsystem.

Because the energy system comprises the energy subsystem connected to the MVC/MVR-subsystem, a portion of energy produced by the MVC/MVR-subsystem can be used in the energy subsystem to be converted into cooling and/or into electricity by the cooling apparatus comprised by the energy subsystem and/or by the electric apparatus comprised by the energy subsystem.

Thus, the energy subsystem can utilize a portion of energy produced by the MVC/MVR-subsystem by using the branched portion of the compressed vapor produced in the MVC/MVR-subsystem and converting the energy in the branched portion of the compressed vapor into another form of energy that can be useful such as cooling and/or electricity.

As an alternative, the energy subsystem can utilize a portion of energy produced by the MVC/MVR-subsystem by using at least the portion of the liquid being heated and converting the energy in at least the portion of the liquid being heated into another form of energy that can be useful such as cooling and/or electricity.

As a further alternative, the energy subsystem can utilize a portion of energy produced by the MVC/MVR-subsystem by using both the branched portion of the compressed vapor produced in the MVC/MVR-subsystem and at least the portion of the liquid being heated in the MVC/MVR-subsystem and converting the energy in the branched portion of the compressed vapor and in at least the portion of the liquid being heated into another form of energy that can be useful such as cooling and/or electricity.

Because the energy subsystem comprises a cooling apparatus configured to convert heat to cooling the heat produced by the MVC/MVR-subsystem can be used to produce cooling, such as for example cooling of residences or cooling in industrial processes.

Because the energy subsystem may comprise an electric apparatus configured to use heat to generate electricity the heat produced by the MVC/MVR-subsystem can be used to produce electricity.

Thus, an energy system is provided, which system has conditions for utilization of a portion of energy produced in the MVC/MVR-subsystem in an efficient manner for converting the energy into another form of energy that can be used.

Consequently, an improved energy system is provided, which energy system has conditions for an improved utilization of energy produced by a MVC/MVR-subsystem.

Therefore, the above mentioned object is achieved.

According to the invention, the cooling apparatus is an absorption chiller or an adsorption chiller. Thus heat energy produced by the MVC/MVR-subsystem can be converted into cooling in an efficient manner by means of an absorption chiller or an adsorption chiller. Another examples of cooling apparatus are thermodynamic cyclic processes, such as ORC, Stirling cycle, thermo-acoustics, adsorption- or absorption-refrigerators or electro-thermal converters such as Peltier elements.

Optionally, the electric apparatus is a thermoelectric generator. Thus, electricity can be produced in an effective manner.

Optionally, the MVC/MVR-subsystem is a MVC/MVR liquid purification subsystem.

Thus, an improved energy system is provided having conditions for producing pure liquid by means of the MVC/MVR-subsystem and for producing energy by means of the energy subsystem connected to the MVC/MVR-subsystem.

Optionally, the MVC/MVR liquid purification subsystem is a MVC/MVR water desalination subsystem.

Optionally, the liquid is water. Thus, an yet improved energy system is provided having conditions for producing pure fresh water by means of the MVC/MVR-subsystem and for producing energy by means of the energy subsystem connected to the MVC/MVR-subsystem.

Hot water, being a high-density energy source, can via thermodynamic cyclic processes such as ORC, Stirling cycle, thermo-acoustics, adsorption- and/or absorption refrigeration, electro-thermal converters such as Peltier elements freely become converted into a cold medium such as solid, fluid, gaseous or a combination of them. The cold medium can for example become utilized for purposes of cooling residences or industrial processes, as integral part of district cooling systems (cold water supply), for air conditioning systems or similar.

A method according to claim 5 describes a further aspect of the invention.

The method comprises:
- connecting an energy subsystem to said MVC/MVR-subsystem and
- using a branched portion of the compressed vapor and/or at least a portion of the liquid being heated to convert energy in the branched portion of the compressed vapor and/or in at least the portion of the liquid being heated into cooling by a cooling apparatus comprised by the energy subsystem and/or to generate electricity by an electric apparatus comprised by the energy subsystem.

Because the energy subsystem is connected to the MVC/MVR-subsystem, a portion of energy produced by the MVC/MVR-subsystem can be used in the energy subsystem.

Thus, the energy subsystem can utilize a portion of energy produced by the MVC/MVR-subsystem by using the branched portion of the compressed vapor produced in the MVC/MVR-subsystem and converting the energy in the portion of the compressed vapor into another form of energy that can be useful such as cooling and/or electricity.

As an alternative, the energy subsystem can utilize a portion of energy produced by the MVC/MVR-subsystem by using at least the portion of the liquid being heated and converting the energy in at least the portion of the liquid being heated into another form of energy that can be useful such as cooling and/or electricity.

As a further alternative, the energy subsystem can utilize a portion of energy produced by the MVC/MVR-subsystem by using both the branched portion of the compressed vapor produced in the MVC/MVR-subsystem and at least the portion of the liquid being heated in the MVC/MVR-subsystem and converting the energy in the portion of the compressed vapor and in at least the portion of the liquid being heated into another form of energy that can be useful such as cooling and/or electricity.

Consequently, an improved method for converting of energy is provided. Therefore, the above mentioned object is achieved.

### Brief description of the drawings

Fig. 1 shows a schematic illustration of an energy system according to the embodiment of the invention.
Fig. 2 shows a schematic illustration of an energy system according to some further examples,
Fig. 3 shows a schematic illustration of an energy system according to some yet further examples.

### Detailed description

The energy system with MVC/MVR-subsystem will now be described in detail with references to the appended figures. Throughout the figures the same, or similar, items have the same reference signs. Moreover, the ,items and the figures are not necessarily to scale, emphasis instead being placed upon illustrating the principles of the invention.

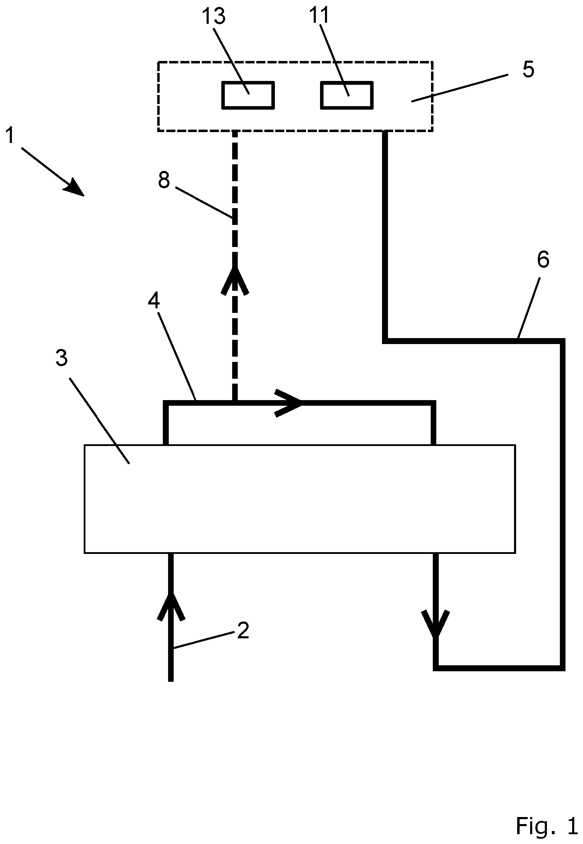

With reference to Fig. 1, an energy system 1 comprising a mechanical vapor compression (MVC) or also called mechanical vapor recompression (MVR) subsystem 3 is illustrated according to the embodiment of the invention.

The MVR-subsystem 3 is arranged as a closed loop vapor MVR-subsystem arranged to reuse the produced vapor. The MVR-subsystem 3 is a subsystem arranged to operate according to MVR-principle known in the art where compressed vapor is reused. The MVR-subsystem 3 is arranged in a specific way characteristic for MVR technology. The MVC/MVR-subsystem 3 is a common knowledge in the art and is therefore not described herein in more details.

The energy system 1 comprises a mechanical vapor compression (MVC/MVR) subsystem 3. arranged to receive a liquid and arranged to produce compressed vapor from the liquid and to heat the liquid being received. The liquid is supplied to the MVC/MVR-subsystem 3 through a liquid supply line 2. The compressed vapor are transported through a compressed vapor line 4. The heated liquid is transported through a heated liquid line 6.

The liquid may be water or the liquid may be any other liquid or mixture of liquids and/or other materials e.g. solids, polymers, fatty alcohols, oils, additives, soluble or insoluble particles and molecular systems including ionic fluids. The heated liquid may then be a heated cleaned water. Thus, the MVC/MVR-subsystem 3 may be a MVC/MVR liquid purification subsystem, particularly a MVC/MVR water desalination subsystem.

According to the embodiments illustrated in Fig. 1, the energy system 1 comprises an energy subsystem 5 connected to the MVC/MVR-subsystem 3 by means of the heated liquid line 6. The energy subsystem 5 is arranged to use the liquid being heated to convert the energy in the heated liquid into another form of energy that can be useful such as cooling and/or electricity. The energy subsystem 5 is directly connected to said MVC/MVR-subsystem 3 by means of the heated liquid line 6.

As an alternative, the energy subsystem 5 can utilize a portion of energy produced by the MVC/MVR-subsystem 3 by using directly a branched portion of the compressed vapor. The branched portion of the compressed vapor can be supplied to the energy subsystem 5 through a compressed vapor portion line 8 illustrated with dashed line. Thus, the energy subsystem 5 can be directly connected to the MVC/MVR-subsystem 3 by means of the compressed vapor portion line 8 supplying the portion of the compressed vapor to the energy subsystem 5.

Consequently, a portion of energy produced by the MVC/MVR-subsystem 3 can be used by direct connection of the energy subsystem 5 to the MVC/MVR-subsystem according to the following alternatives:
- using the liquid being heated in the MVC/MVR-subsystem 3 and supplied to the energy subsystem 5 through the heated liquid line 6 or
- using the portion of the compressed vapor produced in the MVC/MVR-subsystem 3 and supplied through the compressed vapor portion line 8 or
- using both the liquid being heated in the MVC/MVR-subsystem 3 and supplied to the energy subsystem 5 through the heated liquid line 6 and using the portion of the compressed vapor produced in the MVC/MVR-subsystem 3 and supplied through the compressed vapor portion line 8.

According to some embodiments a portion of the heated liquid can be used by the energy subsystem 5.

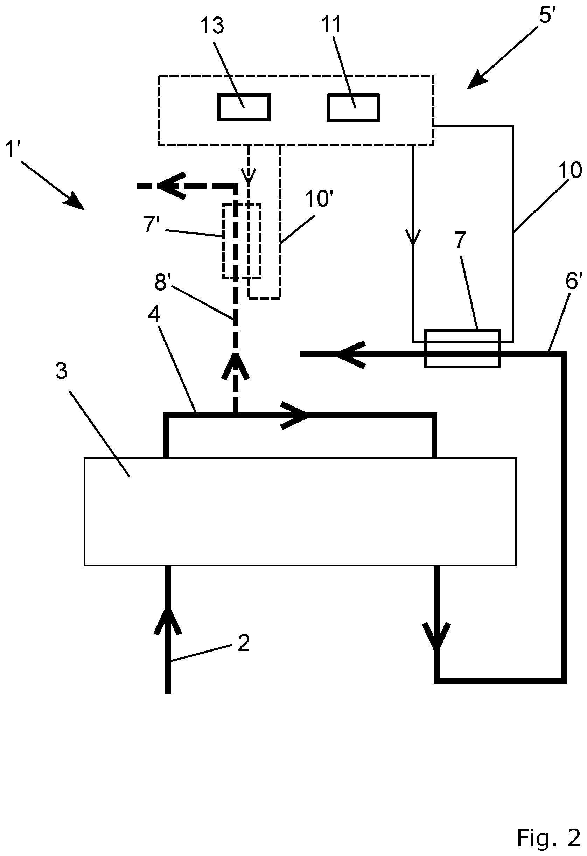

With reference to Fig. 2, an energy system 1' comprising a mechanical vapor compression (MVC/MVR) subsystem 3 and an energy subsystem 5'is illustrated according to further examples.

According to the embodiments illustrated in Fig. 2, the energy subsystem 5' comprises a heat exchanger 7 arranged to provide heat exchange between the liquid being heated in the MVC/MVR-subsystem 3 and transported through a further heated liquid line 6' and a heat medium of the energy subsystem 5' flowing via a heat medium line 10.

As an alternative, the energy subsystem 5'may comprises a further heat exchanger 7' arranged to provide heat exchange between the portion of the compressed vapor transported through a further compressed vapor portion line 8' and a further heat medium flowing via a further heat medium line 10'.

Consequently, a portion of energy produced by the MVC/MVR-subsystem 3 can be used by indirect connection of the energy subsystem 5' to the MVC/MVR-subsystem 3 by providing a heat exchange according to the following alternatives:
- arranging the energy subsystem 5' with the heat exchanger 7 arranged to provide heat exchange between the liquid being heated in the MVC/MVR-subsystem 3 and transported through a further heated liquid line 6' and the heat medium of the energy subsystem 5' flowing via the heat medium line 10 or
- arranging the energy subsystem 5' with the further heat exchanger 7' arranged to provide heat exchange between the portion of the compressed vapor transported through the further compressed vapor portion line 8' and the further heat medium flowing via the further heat medium line 10' or
- arranging the energy subsystem with the heat exchanger 7 arranged to provide heat exchange between the liquid being heated in the MVC/MVR-subsystem 3 and transported through a further heated liquid line 6' and the heat medium of the energy subsystem 5' flowing via a heat medium line 10 and with the further heat exchanger 7' arranged to provide heat exchange between the portion of the compressed vapor transported through the further compressed vapor portion line 8' and the further heat medium flowing via the further heat medium line 10'.

The heat medium and the further heat medium may be water or a medium comprising freon or ammonia or other suitable substances.

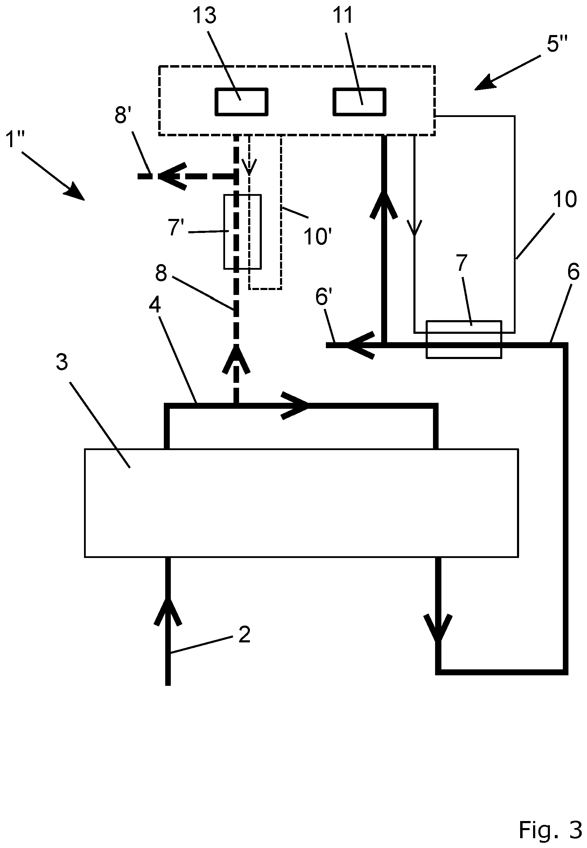

With reference to **Fig. 3** an energy system 1'' comprising a mechanical vapor recompression MVC/MVR subsystem 3 and an energy subsystem 5" is illustrated according to some further examples.

According to the example illustrated in Fig. 3 the energy system 1'' is illustrated being a combination of the energy system 1 illustrated in Fig. 1 and the energy system 1' illustrated in Fig. 2. Thus, in Fig. 3 an energy system 1'' is illustrated showing possible connections of the energy subsystem 5'' to the MVC/MVR-subsystem 3 using possible direct and indirect connection alternatives described in conjunction to Fig. 1 and Fig. 2

The energy subsystems 5. 5' and 5'' described in conjunction to Fig.1, Fig. 2 and Fig. 3 may comprise a cooling apparatus 11 configured to convert heat to cooling. Thus, heat produced by the MVC/MVR-subsystem 3 can be used to produce cooling, such as for example cooling of residences or cooling in industrial processes. The cooling apparatus 11 may be an absorption chiller or an adsorption chiller. Thus heat energy produced by the MVC/MVR-subsystem 3 can be converted into cooling in an efficient manner by means of an absorption chiller or an adsorption chiller. Another examples of cooling apparatus 11 are: thermodynamic cyclic processes, such as ORC, Stirling cycle, thermo-acoustics, adsorption- or absorption-refrigerators or electro-thermal converters such as Peltier elements.

The energy subsystems 5. 5' and 5'' described in conjunction to Fig.1, Fig. 2 and Fig. 3 may also comprise an electric apparatus 13 configured to use heat to generate electricity. Thus, heat produced by the MVC/MVR-subsystem 3 can be used to produce electricity. The electric apparatus 13 may be a thermoelectric generator. Thus, electricity can be produced in an effective manner using heat energy produced by the MVC/MVR-subsystem 3.

Through the application the arrows illustrate the flow direction in the respective line.

## Claims

1. An energy system (1, 1', 1") comprising a mechanical vapor compression (MVC/MVR) subsystem (3) arranged to receive a liquid supplied to an evaporator of the MVC/MVR-subsystem (3) through a liquid supply line (2) and arranged to produce compressed vapor from said liquid and to heat the liquid being received, wherein the MVC/MVR-subsystem (3) is arranged as a closed loop vapor MVC/MVR-subsystem (3) comprising a compressed vapor line (4) and being arranged to reuse the produced compressed vapor being produced in a compressor of the MVC/MVR-subsystem (3) and being provided back through the compressed vapor line (4) to evaporate the liquid and to condense to form a condensed liquid being transported through a heated liquid line (6), wherein
the energy system (1, 1', 1") comprises an energy subsystem (5, 5', 5") connected to said MVC/MVR-subsystem (3) and being arranged to receive a portion of said compressed vapor provided to the energy subsystem (5, 5', 5") through a compressed vapor portion line (8) connected to the compressed vapor line (4) and/or being arranged to use at least a portion of said liquid being heated and being transported through the heated liquid line (6) or through a further heated liquid line 6',
**characterized in that**
the energy subsystem (5, 5', 5") is arranged to convert energy in said portion of the compressed vapor and/or in at least said portion of the liquid being heated into cooling by a cooling apparatus (11) comprised by the energy subsystem (5, 5', 5"), wherein said cooling apparatus (11) is an absorption chiller or an adsorption chiller.

2. The energy system (1, 1', 1") according to any of claim 1, wherein the MVC/MVR-subsystem (3) is a MVC/MVR liquid purification subsystem.

3. The energy system (1, 1', 1") according to claim 2, wherein the MVC/MVR liquid purification subsystem is a MVC/MVR water desalination subsystem.

4. The energy system (1, 1', 1") according to any of claims 1 to 3, wherein the liquid is water.

5. A method for converting energy using an energy system (1, 1', 1") comprising a mechanical vapor compression (MVC/MVR) subsystem (3) arranged to receive a liquid supplied to an evaporator of the MVC/MVR-subsystem (3) through a liquid supply line (2) and arranged to produce compressed vapor from said liquid and to heat the liquid being received, wherein the MVC/MVR-subsystem (3) is arranged as a closed loop vapor MVC/MVR-subsystem (3) comprising a compressed vapor line (4) and being arranged to reuse the produced compressed vapor being produced in a compressor of the MVC/MVR-subsystem (3) and being provided back through the compressed vapor line (4) to evaporate the liquid and to condense to form a condensed liquid being transported through a heated liquid line (6), wherein the method comprises:
- connecting an energy subsystem (5, 5', 5") to said MVC/MVR-subsystem (3) through a compressed vapor portion line (8) to provide a portion of said compressed vapor to the energy subsystem (5, 5', 5") through the compressed vapor portion line (8) connected to the compressed vapor line (4) and/or through the heated liquid line (6) or through a further heated liquid line 6' to provide at least the portion of said liquid being heated to the process subsystem (5, 5', 5") **characterized in that** the method comprises
- using the portion of said compressed vapor and/or at least the portion of said liquid being heated to convert energy in the portion of said compressed vapor and/or in at least the portion of said liquid being heated into cooling by a cooling apparatus (11) comprised by the energy subsystem (5, 5', 5"), wherein said cooling apparatus (11) is an absorption chiller or an adsorption chiller.

## Patentansprüche

1. Energiesystem (1, 1', 1") mit einem Untersystem zur mechanischen Dampfkompression (MVC/MVR) (3), das dazu angeordnet ist, eine Flüssigkeit aufzunehmen, die einem Verdampfer des MVC/MVR-Untersystems (3) durch eine Flüssigkeitszufuhrleitung (2) zugeführt wird, und das dazu angeordnet ist, aus der Flüssigkeit komprimierten Dampf zu erzeugen und die aufgenommene Flüssigkeit zu erhitzen, wobei das MVC/MVR-Untersystem (3) als ein MVC/MVR-Untersystem (3) mit geschlossenem Dampfkreislauf angeordnet ist, das eine Leitung für komprimierten Dampf (4) umfasst und dazu angeordnet ist, den erzeugten komprimierten Dampf, der in einem Kompressor des MVC/MVR-Untersystems (3) erzeugt und durch die Leitung für komprimierten Dampf (4) zurückgeführt wird, wiederzuverwenden, um die Flüssigkeit zu verdampfen und zu kondensieren, um eine kondensierte Flüssigkeit auszubilden, die durch eine Leitung für erhitzte Flüssigkeit (6) transportiert wird,
wobei
das Energiesystem (1, 1', 1") ein Energie-Untersystem (5, 5', 5") umfasst, das mit dem MVC/MVR-Untersystem (3) verbunden ist und dazu angeordnet ist, einen Teil des komprimierten Dampfes zu empfangen, der dem Energie-Untersystem (5, 5', 5") durch eine Leitung für einen Teil des komprimierten Dampfes (8) zugeführt wird, die mit der Leitung für komprimierten Dampf (4) verbunden ist, und/oder dazu angeordnet ist, mindestens einen Teil der Flüssigkeit zu verwenden, die erhitzt wird und durch die Leitung für erhitzte Flüssigkeit (6) oder durch eine weitere Leitung für erhitzte Flüssigkeit (6') transportiert wird,
**dadurch gekennzeichnet, dass**
das Energie-Untersystem (5, 5', 5") dazu angeordnet ist, Energie in dem Teil des komprimierten Dampfes und/oder in mindestens dem Teil der Flüssigkeit, die erhitzt wird, in Kühlung durch ein Kühlgerät (11) umzuwandeln, das in dem Energie-Untersystem (5, 5', 5") enthalten ist, wobei es sich bei dem Kühlgerät (11) um einen Absorptionskühler oder einen Adsorptionskühler handelt.

2. Energiesystem (1, 1', 1") nach Anspruch 1, wobei es sich bei dem MVC/MVR-Untersystem (3) um ein MVC/MVR-Flüssigkeitsreinigungsuntersystem handelt.

3. Energiesystem (1, 1', 1") nach Anspruch 2, wobei es sich bei dem MVC/MVR-Flüssigkeitsreinigungsuntersystem um ein MVC/MVR-Wasserentsalzungsuntersystem handelt.

4. Energiesystem (1, 1', 1") nach einem der Ansprüche 1 bis 3, wobei es sich bei der Flüssigkeit um Wasser handelt.

5. Verfahren zur Energieumwandlung unter Verwendung eines Energiesystems (1, 1', 1") mit einem Untersystem zur mechanischen Dampfkompression (MVC/MVR) (3), das dazu angeordnet ist, eine Flüssigkeit aufzunehmen, die einem Verdampfer des MVC/MVR-Untersystems (3) durch eine Flüssigkeitszufuhrleitung (2) zugeführt wird, und das dazu angeordnet ist, aus der Flüssigkeit komprimierten Dampf zu erzeugen und die aufgenommene Flüssigkeit zu erhitzen, wobei das MVC/MVR-Untersystem (3) als ein MVC/MVR-Untersystem (3) mit geschlossenem Dampfkreislauf angeordnet ist, das eine Leitung für komprimierten Dampf (4) umfasst und dazu angeordnet ist, den erzeugten komprimierten Dampf, der in einem Kompressor des MVC/MVR-Untersystems (3) erzeugt und durch die Leitung für komprimierten Dampf (4) zurückgeführt wird, wiederzuverwenden, um die Flüssigkeit zu verdampfen und zu kondensieren, um eine kondensierte Flüssigkeit auszubilden, die durch eine Leitung für erhitzte Flüssigkeit (6) transportiert wird,
wobei das Verfahren Folgendes umfasst:
- Verbinden eines Energie-Untersystems (5, 5', 5") mit dem MVC/MVR-Untersystem (3) durch eine Leitung für einen Teil des komprimierten Dampfes (8), um einen Teil des komprimierten Dampfes dem Energie-Untersystem (5, 5', 5") durch die Leitung für einen Teil des komprimierten Dampfes (8), die mit der Leitung für komprimierten Dampf (4) verbunden ist, und/oder durch die Leitung für erhitzte Flüssigkeit (6) oder durch eine weitere Leitung für erhitzte Flüssigkeit (6') zuzuführen, um mindestens den Teil der Flüssigkeit, die erhitzt wird, dem Prozess-Untersystem (5, 5', 5") bereitzustellen
**dadurch gekennzeichnet, dass** das Verfahren Folgendes umfasst
- Verwenden des Teils des komprimierten Dampfes und/oder mindestens des Teils der Flüssigkeit, die erhitzt wird, um Energie in dem Teil des komprimierten Dampfes und/oder in mindestens dem Teil der Flüssigkeit, die erhitzt wird, in Kühlung durch ein Kühlgerät (11) umzuwandeln, das in dem Energie-Untersystem (5, 5', 5") enthalten ist, wobei es sich bei dem Kühlgerät (11) um einen Absorptionskühler oder einen Adsorptionskühler handelt.

## Revendications

1. Système d'énergie (1, 1', 1") comprenant un sous-système de compression mécanique de vapeur (MVC/MVR) (3) agencé pour recevoir un liquide alimenté vers un évaporateur du sous-système MVC/MVR (3) par l'intermédiaire d'une conduite d'alimentation en liquide (2) et agencé pour produire de la vapeur comprimée à partir dudit liquide et pour chauffer le liquide reçu, dans lequel le sous-système MVC/MVR (3) est agencé comme un sous-système MVC/MVR (3) à vapeur en boucle fermée comprenant une conduite de vapeur comprimée (4) et qui est agencé pour réutiliser la vapeur comprimée produite, produite dans un compresseur du sous-système MVC/MVR (3) et qui est renvoyée à travers la conduite de vapeur comprimée (4) pour évaporer le liquide et pour se condenser afin de former un liquide condensé qui est transporté à travers une conduite de liquide chauffé (6),
dans lequel le système d'énergie (1, 1', 1") comprend un sous-système d'énergie (5, 5', 5") raccordé audit sous-système MVC/MVR (3) et étant agencé pour recevoir une partie de ladite vapeur comprimée fournie au système d'énergie (5, 5', 5") par l'intermédiaire d'une conduite de partie vapeur comprimée (8) raccordée à la conduite de vapeur comprimée (4) et/ou étant agencé pour utiliser au moins une partie dudit liquide chauffé et transporté par l'intermédiaire de la conduite de liquide chauffé (6) ou par l'intermédiaire d'une autre conduite de liquide chauffé 6',
**caractérisé en ce que** le sous-système d'énergie (5, 5', 5") est agencé pour convertir l'énergie dans ladite partie de la vapeur comprimée et/ou dans au moins ladite partie du liquide qui est chauffée en refroidissement par un appareil de refroidissement (11) compris dans le sous-système d'énergie (5, 5', 5"), dans lequel ledit appareil de refroidissement (11) est un refroidisseur à absorption ou un refroidisseur à adsorption.

2. Système d'énergie (1, 1', 1") selon l'une quelconque de la revendication 1, dans lequel le sous-système MVC/MVR est un sous-système de purification de liquide MVC/MVR.

3. Système d'énergie (1, 1', 1") selon la revendication 2, dans lequel le sous-système de purification de liquide MVC/MVR est un sous-système de dessalement d'eau MVC/MVR.

4. Système d'énergie (1, 1', 1") selon l'une quelconque des revendications 1 à 3, dans lequel le liquide est l'eau.

5. Procédé de conversion d'énergie à l'aide d'un système d'énergie (1, 1', 1") comprenant un sous-système de compression mécanique de vapeur (MVC/MVR) (3) agencé pour recevoir un liquide alimenté vers un évaporateur du sous-système MVC/MVR (3) par l'intermédiaire d'une conduite d'alimentation en liquide (2) et agencé pour produire de la vapeur comprimée à partir dudit liquide et pour chauffer le liquide reçu, dans lequel le sous-système MVC/MVR (3) est agencé comme un sous-système MVC/MVR (3) à vapeur en boucle fermée comprenant une conduite de vapeur comprimée (4) et qui est agencé pour réutiliser la vapeur comprimée produite, produite dans un compresseur du sous-système MVC/MVR (3) et qui est renvoyée à travers la conduite de vapeur comprimée (4) pour évaporer le liquide et pour se condenser afin de former un liquide condensé qui est transporté à travers une conduite de liquide chauffé (6),
dans lequel le procédé comprend :
- le raccordement d'un sous-système d'énergie (5, 5', 5") audit sous-système MVC/MVR (3) à travers une conduite de partie de vapeur comprimée (8) pour fournir une partie de ladite vapeur comprimée au sous-système d'énergie (5, 5', 5") par l'intermédiaire de la conduite de partie de vapeur comprimée (8) raccordée à la conduite de vapeur comprimée (4) et/ou par l'intermédiaire de la conduite de liquide chauffé (6) ou par l'intermédiaire d'une autre conduite de liquide chauffé 6' pour fournir au moins la partie dudit liquide chauffée au sous-système de traitement (5, 5', 5") **caractérisé en ce que** le procédé comprend
- l'utilisation de la partie de ladite vapeur comprimée et/ou au moins la partie dudit liquide qui est chauffée pour convertir l'énergie dans la partie de ladite vapeur comprimée et/ou dans au moins la partie dudit liquide qui est chauffée en refroidissement par un appareil de refroidissement (11) compris dans le sous-système d'énergie (5, 5', 5"), dans lequel ledit appareil de refroidissement (11) est un refroidisseur à absorption ou un refroidisseur à adsorption.
